# EUROPEAN PATENT APPLICATION

(11) **EP 0 840 451 A1**
(43) Date of publication of application: **06.05.1998**
(21) Application number: 96830554.0
(22) Date of filing: 30.10.1996
(51) Int. Cl.: H03K 5/151

(54) **Generator circuit for non overlapping digital signals**

(71) Applicant: SGS-THOMSON MICROELECTRONICS s.r.l., 20041 Agrate Brianza (Milano) (IT)
(72) Inventor: Tomasini, Luciano, 20052 Monza, Milano (IT); Clerici, Giancarlo, 20059 Vimodrone, Milano (IT)

(57) **Abstract**

This invention relates to a non-overlapped signal generating circuit for MOS type integrated devices.

The circuit has at least one input terminal for receiving an input digital signal and at least first (S1) and second (S2) pluralities of output terminals to respectively generate first (P1,P1N,P1D,P1DN) and second (P2,P2N,P2D,P2DN) pluralities of output digital signals.

The output digital signals from the first and second pluralities are in opposed pairs and non-overlapping one another.

The circuit (1) further comprises at least a first logic gate (4) having at least a first input terminal coupled to a circuit node (A), in turn coupled to the input terminal of the generating circuit (1), at least a second input terminal for receiving at least a first output digital signal (P2D) from the second plurality of output digital signals, and at least one output terminal coupled to the first plurality (S1) of output terminals of the generating circuit (1).

In addition, the circuit (1) comprises at least a second logic gate (5) having at least a first input terminal connected to the circuit node (A), at least a second input terminal for receiving at least a second output digital signal (P1D) from the first plurality of output digital signals, and at least one output terminal coupled to the second plurality (S2) of output terminals of the generating circuit (1).

## Description

This invention relates to a circuit generating non-overlapped digital signals, for integrated devices of the MOS type.

The field of this invention is in particular, but not exclusively, that of MOS devices with switched capacitors, and the ensuing description will make reference to such an application for convenience of illustration only.

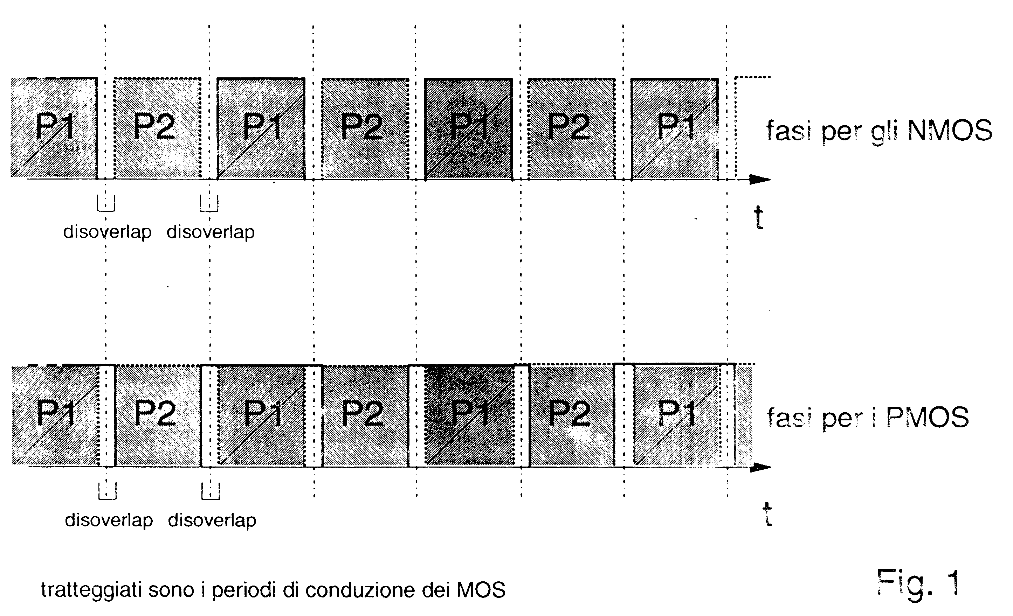

As is known, switched capacitor devices require that digital signals be generated which never are at a high logic level simultaneously, if the device includes N-channel MOS transistors, or simultaneously at a low logic level, if the device includes P-channel MOS transistors, as shown in Figure 1.

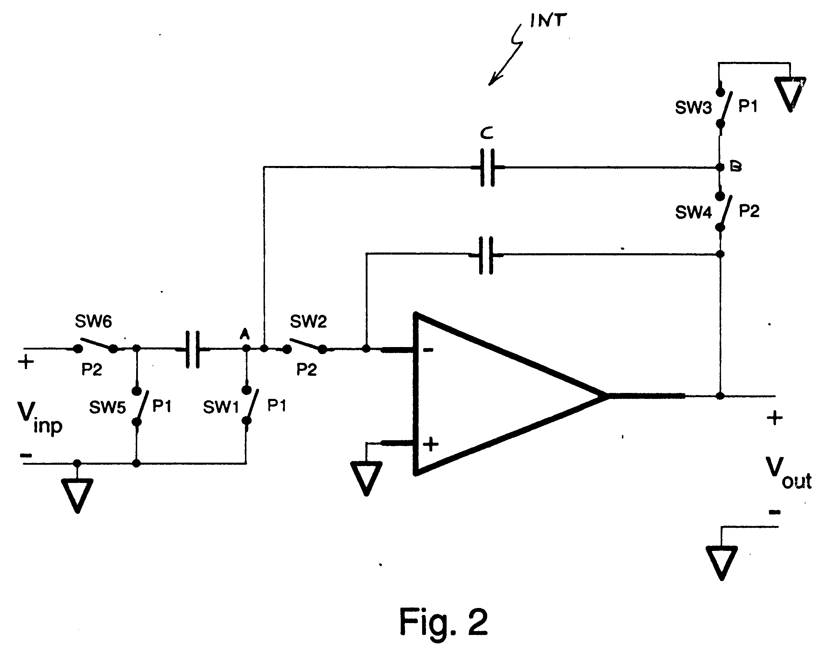

In particular, Figure 2 shows an integrator device INT with loss-switched capacitors, which includes first SW1 and second SW2 switches connected to each other through a first circuit node A, and third SW3 and fourth SW4 switches connected to each other through a second circuit node B.

The integrator device INT further includes a capacitor C connected between the first A and the second B circuit node.

In general, the switches SW1, SW2, SW3 and SW4 are transistors of the MOS type which are driven by opposed digital signals P1 and P2 non-overlapping each other.

It should be noted that is important that these signals be non-overlapped ("disoverlapped" in the industry language), because a loss of information would otherwise occur due to a loss of charge, or current flow, across the capacitor C as the switches SW1, SW2 and/or SW3, SW4 are closed simultaneously.

Where high performance features of the devices in terms of linearity (e.g. greater than 60 dB) are sought, the device shown in Figure 2, wherein the switches SW1, SW2, SW3 and SW4 are only driven by the signals P1 and P2, becomes inadequate.

This because, whereas the voltage at the first SW1 and second SW2 switches is nearly constant, as the first node A is alternatively grounded with the first switch SW1 in the closed state, or virtually grounded with the second switch SW2 closed, the voltage at the third SW3 and fourth SW4 switches is dependent on a voltage signal Vout presented at the output of device INT.

In fact, the second circuit node B is alternatively grounded when the third switch SW3 is closed, or is at the output voltage Vout when the fourth switch SW4 is closed.

This causes phenomena of charge injection and clock feedthrough, which depend on the voltage across the gate and source terminals of the transistors that form the switches, to be more or less constant for the first SW1 and second SW2 switches.

For the third SW3 and fourth SW4 switches, such phenomena depend instead on the output voltage Vout, because it is on this voltage that the voltage across the gate and source terminals of the transistors forming these switches is dependent.

This results in a distortion appearing at the output of the device INT, which is due to the above phenomena and has its amplitude dependent on the amplitude of the signal Vout.

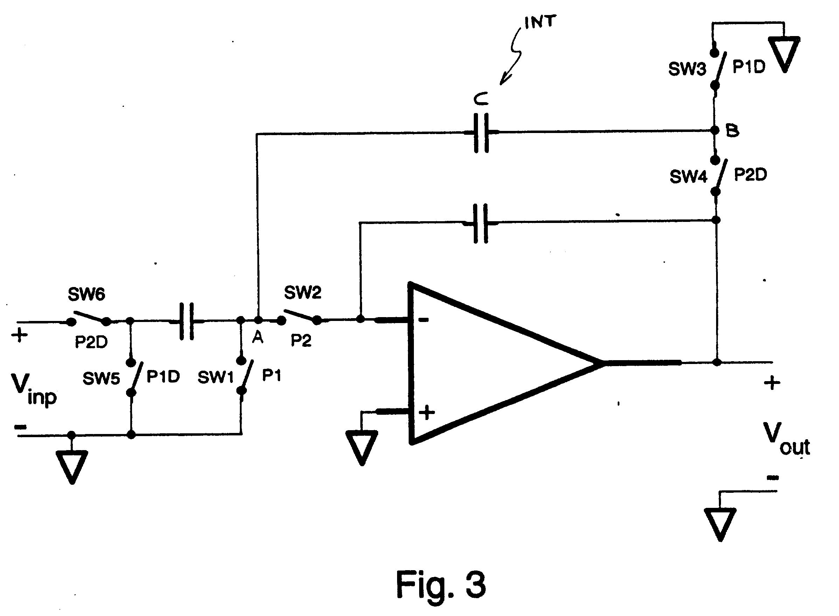

To obviate these drawbacks, the switches SW3 and SW4 are driven by opposed digital signal P1D and P2D which do not overlap each other and are delayed from the signals P1 and P2, as shown in Figure 3.

In this way, it can be ensured that, since the first SW1 and second SW2 switches are always first to open, these will be the only switches to inject charge into the capacitor C.

In addition, since for a great majority of the signals used DC is not a part of the useful signal, this fully solves the problem.

A known technical solution that provides a device generating non-overlapped digital signals to suitably drive the switches included in the integrator device of Figure 2 is shown in Figure 4 and disclosed in Italian Patent No. 1,190,324 to this Applicant.

This prior solution provides for the use of a non-overlapped digital signal generating device 1 which comprises first 2 and second 3 logic gates, respectively of the NAND and NOR type, each having a first input driven by a digital clock signal CKL and a second input controlled by a delay circuit 4.

This circuit, having an input driven by the same clock signal CKL, effectively outputs a digital signal CKLrit which is delayed from the clock signal CKL.

The delay circuit 4 includes a first inverter 5, of a highly resistive type, which has an output connected to ground through a capacitor Crp.

The output of the first inverter 5 is also connected to an input of a second inverter 6 having an output connected to the second inputs of the logic gates 2 and 3.

The device 1 operates as explained herein below.

The charging and discharging of the capacitor Crp, taking the high resistance presented by the first inverter 5 into account, causes the rising and falling edges of the clock signal CKL to be presented to the second inverter 6 with a delay which depends on the RC constant of the system.

Thus, the second inverter 6 will produce at its output the signal CKLrit, identical with the signal CKL but delayed a given time period therefrom.

As a result, the device 1 is enabled to output opposed digital signals F1A and F2A which do not overlap each other, as well as opposed and non-overlapped digital signals F1 and F2 which are delayed from the signals F1A and F2A.

The device 1 is also enabled to generate signals F1A*, F2A*, F1* and F2* being negations of the signals F1A, F2A, F1 and F2.

The underlying technical problem of this invention is to provide a circuit which has such constructional and functional characteristics as to generate digital signals which are markedly disoverlapped from one another.

The circuit of this invention is also highly accurate and easily implemented.

The technical problem is solved by a circuit generating signals with non-overlapping phases, as indicated above and defined in the characterizing portions of the appended claims.

The features and advantages of a circuit according to the invention will be apparent from the following description of an embodiment thereof, given by way of non-limitative example with reference to the accompanying drawings.

In the drawings:
Figure 1 shows respective diagrams, on the same time base, of opposed and non-overlapped digital signals;
Figure 2 shows a first embodiment of a device with switched capacitors according to the prior art;
Figure 3 shows a second embodiment of a device with switched capacitors according to the prior art;
Figure 4 shows a non-overlapped digital signal generating device according to the prior art;
Figure 5 shows a first embodiment of a non-overlapped digital signal generating device according to the invention;
Figure 6 shows a second embodiment of a non-overlapped digital signal generating device according to the invention;
Figure 7 shows digital signals as provided by a simulation of the circuits in Figures 5 and 6.

Referring to the drawing figures, generally and schematically shown at 1 is a circuit generating non-overlapped digital signals for integrated devices of the MOS type.

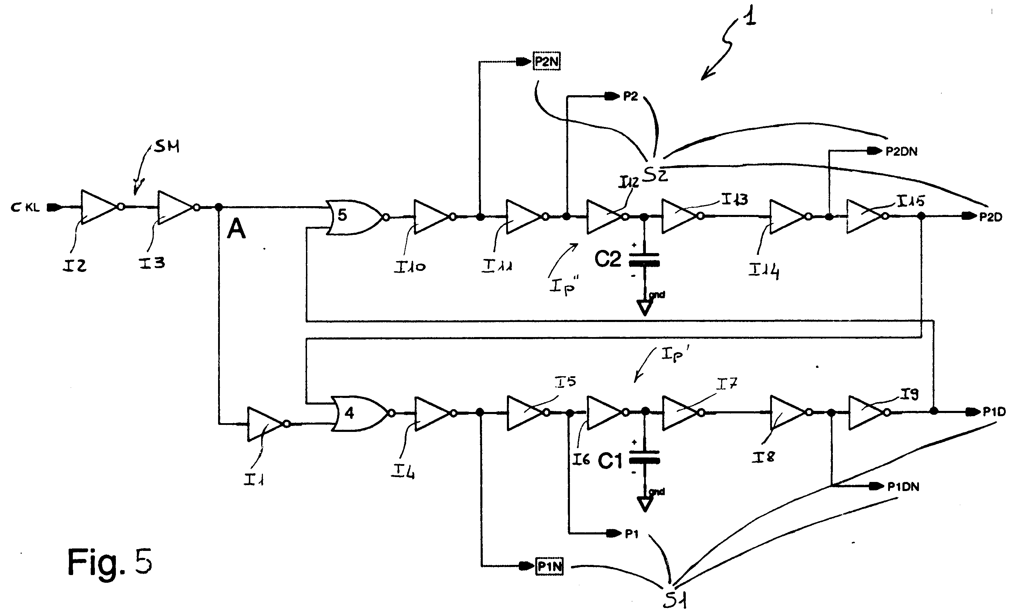

More particularly, with reference to Figure 5, the circuit 1 has at least one input terminal CKL adapted to receive an input digital signal, and at least first S1 and second S2 plurality of output terminals for generating first (P1, P1N, P1D, P1DN) and second (P2, P2N, P2D, P2DN) plurality of output digital signals.

The output digital signals of the first and second pluralities are in opposed pairs and do not overlap one another.

Also with reference to Figure 5, the circuit 1 includes at least a first logic gate 4 of the NOR type which has a first input terminal coupled to a circuit node A, in turn coupled to the input terminal CKL of the circuit 1, and a second input terminal for receiving a first output digital signal P2D.

The first input terminal of the first logic gate 4 is coupled to the circuit node A via a first inverter I1.

The circuit node A, in turn, is coupled to the input terminal CKL of the circuit 1 via a symmetrizing circuit SM which comprises second I2 and third I3 inverters connected in cascade with each other.

The first logic gate 4 also has an output terminal coupled to the first plurality S1 of output terminals of the circuit 1 through a first plurality Ip' of inverters.

The circuit 1 of Figure 5 further includes a second logic gate 5, also of the NOR type, which has a first input terminal connected to the circuit node A and a second input terminal to receive a second output digital signal P1D from the first plurality of output digital signals.

The second logic gate 5 also includes an output terminal coupled to the second plurality S2 of output terminals of the circuit 1 through a second plurality Ip'' of inverters.

Still with reference to Figure 5, in a first most advantageous embodiment of the invention, the first plurality of inverters Ip' comprises fourth I4, fifth I5, sixth I6, seventh I7, eighth I8 and ninth I9 inverters, cascade connected between the output terminal of the first logic gate 4 and a first output terminal of the circuit 1 from the first plurality S1.

This first output terminal is adapted to generate the second output digital signal P1D.

Each inverter has at least one input terminal and at least one output terminal.

More particularly, connected between the output terminal of the fourth inverter I4 and the input terminal of the fifth inverter I5 is a second output terminal of the circuit 1, which belongs to the first plurality S1 to generate a third output digital signal P1N.

Connected between the output terminal of the fifth inverter I5 and the input terminal of the sixth inverter I6 is a third output terminal of the circuit 1, which belongs to the first plurality S1, to generate a fourth output digital signal P1.

A first capacitor C1 is connected between the output terminal of the sixth inverter I6 and a fixed voltage reference GND, and connected between the output terminal of the eighth inverter I8 and the input terminal of the ninth inverter I9 is a fourth output terminal of the circuit 1, which belongs to the first plurality S1, to generate a fifth output digital signal P1DN.

It should be noted that the signal P1D is delayed from the signal P1, and that the signals P1N and P1DN are negations of the signals P1 and P1D, respectively.

The second plurality of inverters Ip'' then includes tenth I10, eleventh I11, twelfth I12, thirteenth I13, fourteenth I14 and fifteenth I15 inverters connected in cascade between the output terminal of the second logic gate 5 and a fifth output terminal of the circuit 1, which belongs to the second plurality S2, to generate the first output digital signal P2D.

Each inverter has at least one input terminal and at least one output terminal.

More particularly, connected between the output terminal of the tenth inverter I10 and the input terminal of the eleventh inverter I11 is a sixth output terminal of the circuit 1, which belongs to the second plurality S2, to generate a sixth output digital signal P2N.

Connected between the output terminal of the eleventh inverter I11 and the input terminal of the twelfth inverter I12 is a seventh output terminal of the circuit 1, which belongs to the second plurality S2, to generate a seventh output digital signal P2.

A second capacitor C2 is connected between the output terminal of the twelfth inverter I12 and the fixed voltage reference GND, and between the output terminal of the fourteenth inverter I14 and the input terminal of the fifteenth inverter I15 there is connected an eighth output terminal of the circuit 1, which belongs to the second plurality S2, to generate an eighth P2DN output digital signal.

It should be noted that the signal P2D is delayed from the signal P2, and that the signals P2N and P2DN are negations of the signals P2 and P2D, respectively.

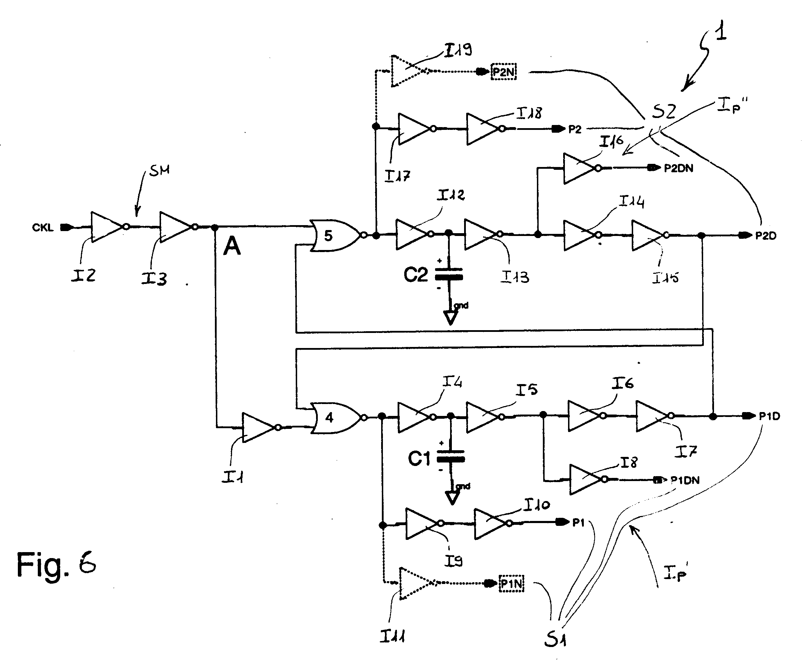

Referring now to Figure 6, in a second embodiment of the invention, the first plurality of inverters Ip' comprises fourth I4, fifth I5, sixth I6 and seventh I7 inverters connected in cascade between the output terminal of the first logic gate 4 and the first output terminal of the circuit 1.

Each inverter has at least one input terminal and at least one output terminal.

A first capacitor C1 is connected between the output terminal of the fourth inverter I4 and a fixed voltage reference GND.

The first plurality of inverters Ip' also comprises an eighth inverter I8 having an input terminal connected to both the output terminal of the fifth inverter I5 and the input terminal of the sixth inverter I6.

The inverter I8 also includes an output terminal corresponding to the fourth output terminal of the circuit 1.

The first plurality of inverters Ip' further comprises ninth I9 and tenth I10 inverters connected in cascade between the output terminal of the first logic gate 4 and the third output terminal of the circuit 1.

In this second embodiment, the first plurality of inverters Ip' additionally comprises an eleventh inverter I11 connected between the output terminal of the first logic gate 4 and the second output terminal of the circuit 1.

Similarly, the second plurality of inverters Ip'' comprises twelfth I12, thirteenth I13, fourteenth I14 and fifteenth I15 inverters connected in cascade between the output terminal of the second logic gate 5 and the fifth output terminal of the circuit 1.

Each inverter has at least one input terminal and at least one output terminal.

A second capacitor C2 is connected between the output terminal of the twelfth inverter I12 and the fixed voltage reference GND.

The second plurality of inverters Ip'' also comprises a sixteenth inverter I16 having an input terminal connected to both the output terminal of the thirteenth inverted I13 and the input terminal of the fourteenth inverter I14.

The inverter I16 has an output terminal corresponding to the eighth output terminal of the circuit 1.

Also, the second plurality of inverters Ip'' comprises seventeenth I17 and eighteenth I18 inverters connected in cascade between the output terminal of the second logic gate 5 and the seventh output terminal of the circuit 1.

In this second embodiment, the second plurality of inverters Ip'' additionally comprises a nineteenth inverter I19 connected between the output terminal of the second logic gate 5 and the sixth output terminal of the circuit 1.

The operation of the circuit 1 according to the invention will now be described.

It should be noted that the symmetrizing circuit SM is only operative to symmetrize the edges of the input signal CKL which, once processed, will deliver the output digital signals from the circuit 1 in a disoverlapped condition, at the same frequency as the signal CKL.

The inverter I3 also functions to cause at least one input terminal of one of the logic gates, 4 or 5, to be at a logic "1", thereby driving the output of this gate to a logic "0".

The instance of a logic "1" being presented at the circuit node A will now be analysed.

In this case, the output terminal of the second logic gate 5 is at the logic "0", as are the signals P2 and P2D.

Consequently, the input terminals of the first logic gate 4 also are at the logic "0", so that the output terminal of the same gate is at the logic "1", as are the signals P1 and P1D.

When a logic "0" is presented at the circuit node A, the output terminal of the second logic gate 5 remains at the logic "0" because its input terminal is driven to a logic "0" by the signal P1D still being at the logic "1", while the output terminal of the first logic gate 4 goes to the logic "0", as does the signal P1.

As for the signal P1D, this will go to the logic "0" after a time delay introduced by the first capacitor C1 being charged through a P-channel MOS transistor included in the inverter I5.

At this point, the output terminal of the second logic gate 5 also goes to the logic "1", since two logic "0s" are present at its input terminals.

Directly afterwards, the output signal P2 will go to the logic "1", while the output signal P2D will go to the logic "1" after a time delay introduced by the second capacitor C2 being discharged through an N-channel MOS transistor included in the inverter I14.

The other half-cycle of the circuit 1 operation is quite similar to that just described, with the difference that the delay times are provided by the second capacitor C2 being charged through the P-channel MOS transistor and the first capacitor C1 discharged through the N-channel MOS transistor.

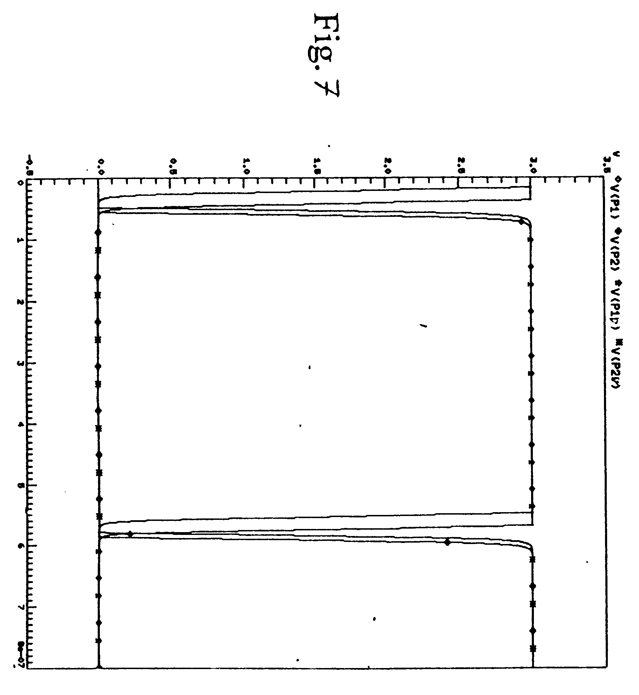

In conclusion, the circuit of this invention can provide output digital signals which are sure disoverlapped by that the fall of one of them is necessary for the other to rise, as shown in Figure 7.

Furthermore, the implementation of the circuit 1 by means of the chain circuit structure with no parallel vias shown in Figure 5 allows of easier matching of the various transistors which implement the inverters, as well as of improved accuracy in generating disoverlapped signals.

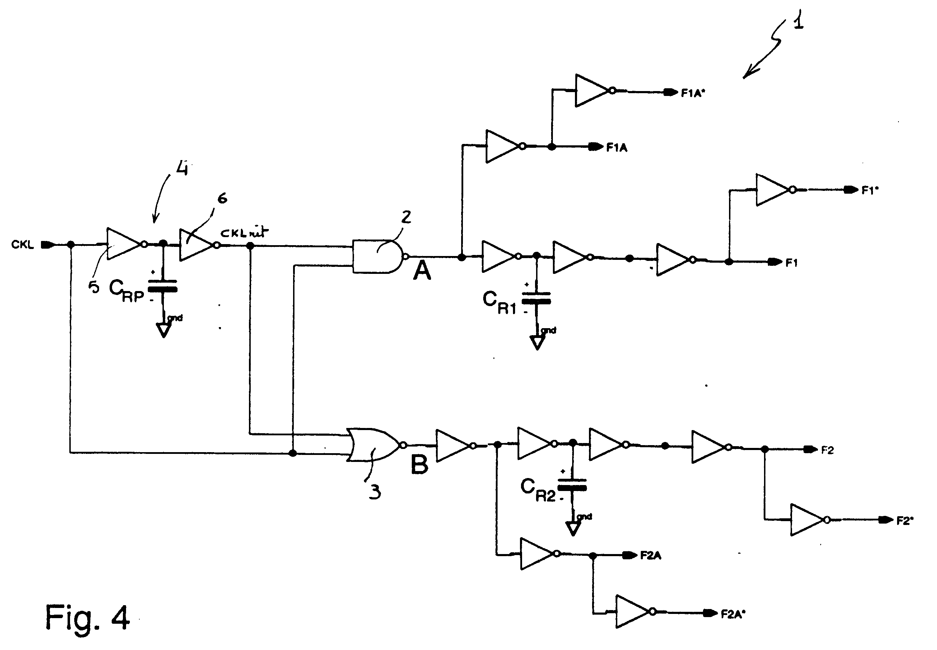

In addition, the four delayed signals P1D, P1DN, P2D, P2DN are generated using only two capacitors (C1 and C2) instead of three as in the device shown in Figure 4, and by manipulating the parameters of the MOS transistors which produce them.

## Claims

1. A non-overlapped signal generating circuit for MOS type integrated devices having at least one input terminal for receiving an input digital signal and at least first (S1) and second (S2) pluralities of output terminals to respectively generate first (P1,P1N,P1D,P1DN) and second (P2,P2N,P2D,P2DN) pluralities of output digital signals, said output digital signals from the first and second pluralities being in opposed pairs and non-overlapping one another, characterized in that it comprises:
at least a first logic gate (4) having at least a first input terminal coupled to a circuit node (A), in turn coupled to the input terminal of the generating circuit (1), at least a second input terminal for receiving at least a first output digital signal (P2D) from the second plurality of output digital signals, and at least one output terminal coupled to the first plurality (S1) of output terminals of the generating circuit (1);
at least a second logic gate (5) having at least a first input terminal connected to the circuit node (A), at least a second input terminal for receiving at least a second output digital signal (P1D) from the first plurality of output digital signals, and at least one output terminal coupled to the second plurality (S2) of output terminals of the generating circuit (1).

2. A signal generating circuit according to Claim 1, characterized in that the circuit node (A) is coupled to the input terminal of the generating circuit (1) through at least one symmetrizing circuit (SM).

3. A signal generating circuit according to Claim 1, characterized in that the first input terminal of the first logic gate (4) is coupled to the circuit node (A) through at least a first inverter (I1).

4. A signal generating circuit according to Claim 1, characterized in that the first (4) and second (5) logic gates are of the NOR type.

5. A signal generating circuit according to Claim 1, characterized in that the output terminal of the first logic gate (4) is coupled to the first plurality (S1) of output terminals of the circuit (1) through a first plurality (Ip') of inverters.

6. A signal generating circuit according to Claim 5, characterized in that the output terminal of the second logic gate (5) is coupled to the second plurality (S2) of output terminals of the circuit (1) through a second plurality (Ip'') of inverters.

7. A signal generating circuit according to Claim 5, characterized in that a first capacitor (C1) is connected between an output terminal of one of said first plurality (Ip') of inverters and a fixed voltage reference (GND).

8. A signal generating circuit according to Claim 6, characterized in that a second capacitor (C2) is connected between an output terminal of one of said second plurality (Ip'') of inverters and a fixed voltage reference (GND).

9. A MOS type of integrated device including at least one switched capacitor filter coupled to at least one circuit generating non-overlapped digital signals, characterized in that said generating circuit is as claimed in Claims 1 to 8.
